# EUROPEAN PATENT APPLICATION

(11) **EP 1 918 341 A1**
(43) Date of publication of application: **07.05.2008**
(21) Application number: 06782259.3
(22) Date of filing: 03.08.2006
(51) Int. Cl.: C09J 7/00, C09J 163/00, C09J 179/08

(54) **ADHESIVE FILM AND SEMICONDUCTOR DEVICE USING SAME**

(30) Priority: 05.08.2005 JP 2005228101
(71) Applicant: Hitachi Chemical Company, Ltd., Tokyo 163-0449 (JP)
(72) Inventor: KITAKATSU, Tsutomu c/o Hitachi Chemical Co., ltd., Hitachi-shi, Ibaraki 317-8555 (JP)
(74) Representative: HOFFMANN EITLE
(86) International application number: PCT/JP2006/315399
(87) International publication number: WO 2007/018120

(57) **Abstract**

The present invention relates to an adhesive film comprising a polyimide resin (A) and a thermosetting resin (B), wherein the polyimide resin (A) comprises a polyimide resin having a repeating unit represented by a formula (I) shown below, and the storage elastic modulus of the adhesive film at 250°C, following heat treatment at a temperature of 150 to 230°C for a period of 0.3 to 5 hours, is not less than 0.2 MPa: 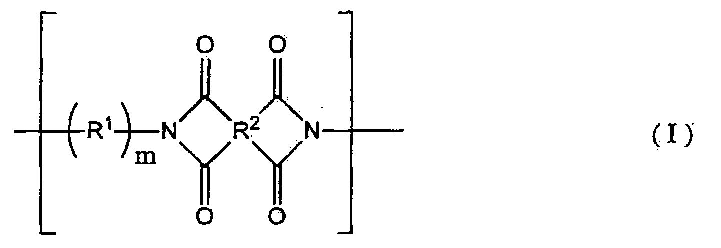 (wherein, the m R¹ groups each represent, independently, a bivalent organic group, the m R¹ groups include a total of k organic groups selected from the group consisting of -CH₂-, -CHR- and -CR₂- (wherein, R represents a non-cyclic alkyl group of 1 to 5 carbon atoms), m represents an integer of not less than 8, m and k satisfy a relationship: k/m ≥ 0.85, and R² represents a tetracarboxylic acid residue).

## Description

### TECHNICAL FIELD

The present invention relates to an adhesive film. The present invention relates particularly to an adhesive film that can be used favorably for bonding a semiconductor element such as an IC or LSI to another semiconductor element, or for bonding a semiconductor element to a support member such as a lead frame or an insulating support substrate. Furthermore, the present invention also relates to a semiconductor device produced using the adhesive film.

### BACKGROUND ART

Conventionally, Au-Si eutectic alloys, solders, or silver pastes or the like have been used for bonding an IC or LSI to a lead frame. Although Au-Si eutectic alloys exhibit high levels of heat resistance and moisture resistance, they have high elastic modulus values, making them prone to cracking when used with large chips, and are also very expensive. Although solders are cheap, they exhibit poor heat resistance, and also have high elastic modulus values like Au-Si eutectic alloys, making them unsuitable for application to large chips.

In contrast, silver pastes are cheap, exhibit a high level of moisture resistance, offer the lowest elastic modulus values among these three materials, and also have sufficient heat resistance to enable use with a 350°C thermocompression wire bonder, and as a result, are currently the most commonly used adhesive materials for bonding ICs and LSIs to lead frames. However, as the level of integration of IC and LSI chips has increased in recent years, leading to corresponding increases in chip size, attempts to bond IC or LSI chips to lead frames using silver paste require the silver paste to be applied and spread across the entire chip surface, and this leads to significant difficulties.

Microelectronic Manufacturing and Testing (October 1985) reported an adhesive film for die bonding in which a thermoplastic resin is filled with a conductive filler. When this adhesive film is used, the adhesive film and a chip are mounted on top of a lead frame, and by heating the adhesive film to a temperature close to the melting point of the thermoplastic resin and applying pressure, the chip is affixed to the lead frame. In the conductive adhesive film reported in the above periodical, selection and use of a thermoplastic resin with a low melting point enables the bonding temperature to be lowered, thereby minimizing oxidation of the lead frame and damage to the chip. However, because the adhesive strength upon heating is poor, the adhesive film is unable to withstand heat treatments conducted following the die bonding such as wire bonding or encapsulation processes. If a thermoplastic resin with a high melting point is used in order to enable the film to withstand these types of heat treatments, then the bonding temperature increases, increasing oxidation of the lead frame and chip damage. In order to resolve this problem, an adhesive film that uses a specific polyimide resin, or an adhesive film for die bonding in which a conductive filler or inorganic filler is added to a specific polyimide resin have been proposed (for example, see Japanese Patent Laid-Open No. H06-145639, Japanese Patent Laid-Open No. H07-228697).

The types of adhesive films for die bonding described above suffer less damage to the lead frame and chip than films using conventional thermoplastic resins, and also exhibit excellent adhesive strength upon heating. However, when used with insulating support substrates comprising an organic compound as the primary component, bonding must be conducted at a lower temperature in order to prevent deformation and the like of the support substrate. In order to address this requirement, an adhesive film for die bonding that comprises a polyimide resin with a reduced glass transition temperature has been developed (for example, see Japanese Patent Laid-Open No. H10-330723).

An adhesive film for die bonding has also been developed in which by introducing long-chain organic groups, a film can be obtained that exhibits favorable reliability under conditions of high temperature and high humidity, as ascertained by a HAST test or the like, and also has favorable low-temperature bonding properties, together with superior reflow resistance upon mounting and excellent reliability relative to temperature and humidity (for example, see Japanese Patent Laid-Open No. 2004-210805).

### DISCLOSURE OF INVENTION

However, even for adhesive films for die bonding comprising introduced long-chain organic groups, if used across a wide range of package configurations, then the reflow resistance may deteriorate depending on the particular example. Specifically, in those cases where an organic substrate (rather than a metal frame) is used as the adhesion target, variations in the nature or quality of the organic substrate, or insufficient drying or dehumidifying of the organic substrate prior to die bonding, may result in a deterioration in the reflow resistance.

An object of the present invention is to provide an adhesive film for die bonding that can be used with all manner of package configurations, and exhibits favorable adhesive strength upon heating, a high level of reflow resistance and superior reliability. Furthermore, another object of the present invention is to provide a highly reliable semiconductor device by using the above adhesive film for die bonding.

The present invention provides an adhesive film for die bonding comprising a combination of a thermoplastic resin containing introduced long-chain organic groups, and a thermosetting resin, wherein the elastic modulus upon heating has been regulated.
In other words, the present invention relates to an adhesive film comprising a polyimide resin (A) and a thermosetting resin (B), wherein the polyimide resin (A) comprises a polyimide resin having a repeating unit represented by a formula (I) shown below, and the storage elastic modulus of the adhesive film at 250°C, following heat treatment at a temperature of 150 to 230°C for a period of 0.3 to 5 hours, is not less than 0.2 MPa. 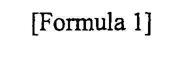 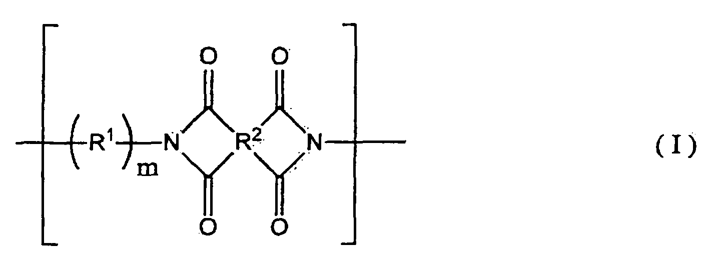 (wherein, the m R¹ groups each represent, independently, a bivalent organic group, the m R¹ groups include a total of k organic groups selected from the group consisting of -CH₂-, -CHR- and -CR₂- (wherein, R represents a non-cyclic alkyl group of 1 to 5 carbon atoms), m represents an integer of not less than 8, m and k satisfy a relationship: k/m ≥ 0.85, and R² represents a tetracarboxylic acid residue) As a result, the adhesive film of the present invention is able to provide reflow resistance and reliability that are at least as favorable as those of conventional adhesive films for die bonding, as well as superior low-temperature bonding properties, for a wide range of package configurations.
The adhesive film of the present invention preferably has a storage elastic modulus at 125°C prior to heat treatment of not less than 0.1 MPa.
Furthermore, in the adhesive film of the present invention, the polyimide resin (A) preferably comprises a polyimide resin obtained by reacting a diamine and a tetracarboxylic dianhydride, and the diamine preferably comprises not less than 50 mol% of a diamine represented by a formula (II) shown below. 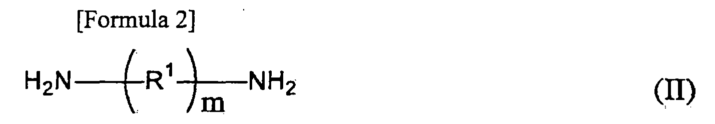 (wherein, the m R¹ groups each represent, independently, a bivalent organic group, the m R¹ groups include a total of k organic groups selected from the group consisting of -CH₂-, -CHR- and -CR₂- (wherein, R represents a non-cyclic alkyl group of 1 to 5 carbon atoms), m represents an integer of not less than 8, and m and k satisfy a relationship: k/m ≥ 0.85)
By using a compound with superior resistance to hydrolysis as the polyimide resin raw material, a further improvement in reliability can be realized.
Furthermore, in the adhesive film of the present invention, the tetracarboxylic dianhydride preferably comprises not less than 60 mol% of a tetracarboxylic dianhydride represented by a formula (III) shown below. 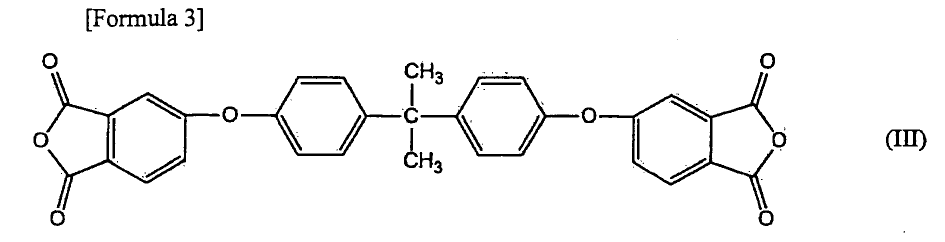 In the present invention, the thermosetting resin (B) preferably comprises an epoxy resin (B1) and an epoxy resin curing agent (B2). Moreover, the epoxy resin (B1) preferably comprises a novolak epoxy resin represented by a formula (IV) shown below. 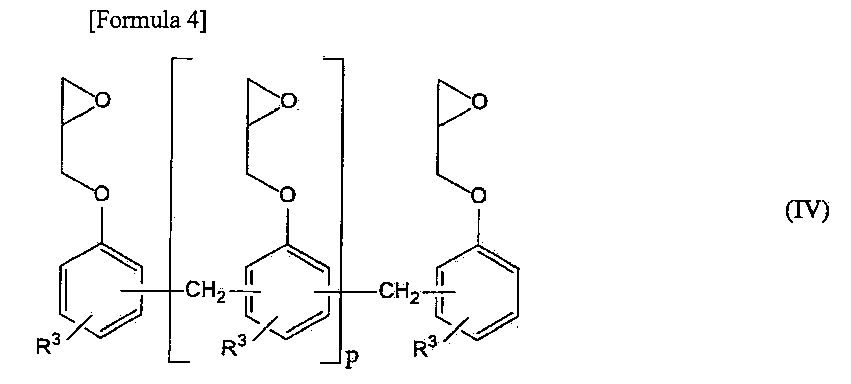 (wherein, each of the plurality of R³ groups represents, independently, a hydrogen atom, an alkyl group of 1 to 5 carbon atoms that may contain a substituent group, or a phenyl group that may contain a substituent group, and p represents an integer from 1 to 20)
Furthermore, the epoxy resin curing agent (B2) preferably comprises a phenol-based compound with a number average molecular weight within a range from 400 to 1,500 that contains two or more hydroxyl groups within each molecule.
Furthermore, the epoxy resin curing agent (B2) preferably comprises a naphthol-based compound that contains three or more aromatic rings within each molecule, or a trisphenol-based compound.
The adhesive film of the present invention may also comprise a filler (C).
The filler (C) preferably has an average particle size of not more than 10 µm and a maximum particle size of not more than 25 µm.
The adhesive film of the present invention preferably comprises from 1 to 200 parts by weight of the thermosetting resin (B) per 100 parts by weight of the polyimide resin (A).
Furthermore, the adhesive film of the present invention preferably comprises from 1 to 8,000 parts by weight of the filler (C) per 100 parts by weight of the component (A).
Furthermore, another aspect of the present invention relates to a semiconductor device having a structure in which the adhesive film described above is used to bond together a semiconductor element and a semiconductor element, or a semiconductor element and a support member.
As a result of using the above adhesive film, the semiconductor device of the present invention exhibits superior reliability.
This application is related to the subject matter disclosed in prior Japanese Patent Application 2005-228101 filed on August 5, 2005, the entire contents of which are incorporated herein by reference.

### BRIEF DESCRIPTION OF THE DRAWINGS

Fig. 1 is a schematic cross-sectional view of an adhesive film formed solely from an adhesive layer, which represents one embodiment of the adhesive film of the present invention.
Fig. 2 is a schematic cross-sectional view of an adhesive film prepared by layering an adhesive layer on top of a base film, which represents one embodiment of the adhesive film of the present invention.
Fig. 3 is a schematic cross-sectional view of an adhesive film that is able to perform the roles of both a die bonding film and a dicing tape, which represents one embodiment of the adhesive film of the present invention.
Fig. 4 is a schematic cross-sectional view of a semiconductor device that represents one example of a method of using the adhesive film of the present invention.
Fig. 5 is a cross-sectional view of a measuring apparatus used for measuring peel strength.

### BEST MODE FOR CARRYING OUT THE INVENTION

An adhesive film of the present invention comprises a polyimide resin (A) and a thermosetting resin (B), wherein the polyimide resin (A) comprises a polyimide resin having a repeating unit represented by a formula (I) shown below. 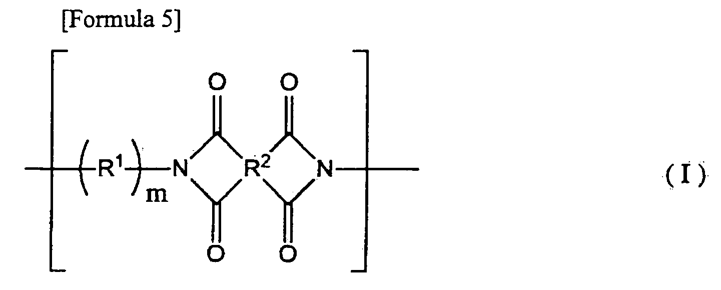 In the formula, the m R¹ groups each represent, independently, a bivalent organic group, and m represents an integer of not less than 8. Of the m R¹ groups, the total number of -CH₂-, -CHR- and -CR₂- groups (wherein, R represents a non-cyclic alkyl group of 1 to 5 carbon atoms) is k, wherein k and m satisfy: k/m ≥ 0.85. R² represents a tetracarboxylic acid residue.

R¹ represents a bivalent organic group, and represents the smallest unit (segment). Specific examples include -CH₂-, CHR-, -CR₂-, -NH-, -CO-, -Ar-, -S- and -SO-. The polyimide resin represented by the formula (I) comprises predominantly -CH₂-, -CHR- and/or -CR₂- groups (hereafter also abbreviated as methylene groups) as the R¹ groups. As a result, the bonding temperature during bonding of a semiconductor element to a supporting member (or to another semiconductor element) using the adhesive film of the present invention can be reduced (to 120 to 160°C), and moreover, an adhesive film with excellent resistance to moisture absorption can be obtained.

The total number m of the bivalent organic groups R¹ and the total number k of methylene groups satisfy the relational formula: k/m ≥ 0.85, preferably satisfy k/m ≥ 0.90, and most preferably satisfy k/m ≥ 0.95. If k/m < 0.85, then moisture absorption tends to increase, and the reflow crack resistance tends to deteriorate.

Moreover, the R¹ groups preferably include no polar groups or polar atoms (such as oxygen atoms or nitrogen atoms). If the R¹ groups include a large number of polar groups or polar atoms, then moisture absorption tends to increase, and the reflow crack resistance tends to deteriorate.

In order to enable bonding (between a semiconductor element and a support member, or between semiconductor elements, this definition also applies below) at lower temperatures (120 to 160°C) than those conventionally used, m satisfies m ≥ 8, and preferably m ≥ 10. Although there are no particular restrictions on the upper limit for the value of m, in terms of ensuring ready availability of the diamine preferably used as a raw material, m preferably satisfies m ≤ 40. Because the low-temperature bonding properties tend to improve with increasing values of m, the same low-temperature bonding effects can be achieved even with numerical values of m exceeding 40. If the value of m is less than 8, then because the molecular chain length shortens for the number of mols of diamine used, the low-temperature bonding effect tends to diminish.

R is a non-cyclic alkyl group of 1 to 5 carbon atoms, and is preferably a linear alkyl group of 1 to 5 carbon atoms. Examples of non-cyclic alkyl groups of 1 to 5 carbon atoms include unsubstituted linear alkyl groups of 1 to 5 carbon atoms and linear alkyl groups of 1 to 5 carbon atoms substituted with an alkyl group of 1 to 3 carbon atoms, and specific examples include a methyl group, ethyl group, n-propyl group, isopropyl group, n-butyl group, isobutyl group, s-butyl group, t-butyl group, n-pentyl group, 1-methylbutyl group, 2-methylbutyl group, 3-methylbutyl group, 1,1-dimethypropyl group, 1,2-dimethylpropyl group, 2,2-dimethylpropyl group, and 1-ethylpropyl group.

Even if the moisture absorption properties of the adhesive film are suppressed to low levels, if the substrate that functions as the adhesion target generates a large quantity of volatile components, then the existence of these volatile components may cause foaming of the adhesive film, which can lead to reflow cracking. Potential reasons for the generation of volatile components include the moisture absorption properties of the substrate, inadequate drying of the substrate, or partial decomposition of the resin component of the substrate.

In order to obtain favorable reflow crack resistance even under the effect of volatile components, the storage elastic modulus of the adhesive film at 250°C following heat treatment is not less than 0.2 MPa. This storage elastic modulus is even more preferably not less than 0.5 MPa, and is most preferably 1 MPa or greater. If the storage elastic modulus at 250°C is less than 0.2 MPa, then the frequency of cracking caused by volatile components generated from the substrate during reflow (at high temperature) tends to increase. Furthermore, the storage elastic modulus of the adhesive film at 250°C is preferably not more than 1,000 MPa. If the storage elastic modulus exceeds 1,000 MPa, then the semiconductor element may sustain damage as a result of stress. 250°C is a temperature in the vicinity of the reflow temperature.

An adhesive film following heat treatment, namely, an adhesive film in which curing has progressed satisfactorily, refers to an adhesive film which has been imparted with a heat history corresponding with a semiconductor element molding step. An example of heat history involves heating at a temperature of 150 to 230°C for a period of 0.3 to 5 hours (18 to 300 minutes), and a heat history involving heating at 180°C for one hour is particularly desirable.

This storage elastic modulus can be measured, for example, using a dynamic viscoelasticity measuring apparatus, using a temperature dependency measurement mode in which a tensile load is applied to the adhesive film, and measurement is conducted from -50 to 300°C under conditions including a frequency of 1 Hz and a rate of temperature increase of 5°C/minute.

Examples of methods of raising the storage elastic modulus upon heating following curing include methods in which the quantity of the thermosetting resin is increased, methods in which the cross-linking density of the thermosetting resin is increased, for example by increasing the number of epoxy groups in those cases where an epoxy resin is used as the thermosetting resin, methods in which larger quantities of metals and/or inorganic fillers are added, and methods in which a polyimide resin containing introduced reactive functional groups is used in combination with the polyimide resin in a quantity that does not cause a marked increase in the moisture absorption of the adhesive film. Any of these methods can be used in isolation, or a combination of a plurality of methods may also be employed.

Furthermore, a reduction in reflow resistance is sometimes observed when a temperature exceeding 200°C is applied suddenly during die bonding. For example, in order to achieve improved miniaturization and reduced device thickness, many modem semiconductor devices employ so-called stacked packages in which semiconductor elements are stacked on top of one another, and the heating temperature used during die bonding of these stacked packages is sometimes considerably higher than that used for non-stacked devices. Moreover, in order to improve productivity, examples in which the bonding temperature is raised to a temperature +10 to +80°C higher than the recommended bonding temperature, thereby shortening the bonding time and increasing the throughput, are also known. Consequently, an adhesive film for die bonding that can be used across a wide range of applications is preferably capable of bonding at low temperatures while still being resistant to more severe bonding conditions, and preferably also exhibits superior reflow resistance.

For example, in those cases where the quantity of volatile components generated from the substrate that functions as the adhesion target increases, and the bonding temperature exceeds 200°C, the adhesive film may foam during bonding, and residual bubbles may remain within the adhesive film, which can cause reflow cracking.

In order to ensure favorable reflow crack resistance even at high bonding temperatures, the storage elastic modulus at 125°C of the adhesive film prior to heat treatment is preferably not less than 0.1 MPa, even more preferably not less than 0.2 MPa, and is most preferably 0.5 MPa or greater. If the storage elastic modulus at 125°C is less than 0.1 MPa, then the frequency of cracking caused by volatile components generated from the substrate during bonding or reflow (at high temperature) tends to increase. Furthermore, the storage elastic modulus at 125°C is preferably not more than 1,000 MPa. If this storage elastic modulus exceeds 1,000 MPa, then the bonding of the adhesive film to wafers tends to become difficult. 125°C is a temperature in the vicinity of the bonding temperature.

The most simple and appropriate methods of raising the storage elastic modulus upon heating prior to heat treatment include methods in which the step of forming the adhesive film and volatilizing the solvent is conducted under higher temperature conditions, and methods in which heating is conducted over an extended period. Moreover, supplementary methods which may be used in combination with the above methods include methods in which the quantity of the thermosetting resin is increased, methods in which the cross-linking density of the thermosetting resin is increased, for example by increasing the number of epoxy groups in those cases where an epoxy resin is used as the thermosetting resin, methods in which larger quantities of metals and/or inorganic fillers are added, and methods in which a polyimide resin containing introduced reactive functional groups is used in combination with the polyimide resin in a quantity that does not cause a marked increase in the moisture absorption of the adhesive film. Any of these methods can be used in isolation, or a combination of a plurality of methods may also be employed.

The weight average molecular weight of the polyimide resin is preferably within a range from 10,000 to 500,000, even more preferably from 20,000 to 300,000, and is most preferably from 30,000 to 200,000. If the molecular weight is less than 10,000, then the properties of the thermosetting resin do not manifest satisfactorily, and the strength of the adhesive film may deteriorate. If the molecular weight exceeds 500,000, then the reaction time required for a typical solution polymerization method becomes overly long, making the production uneconomic, and moreover, re-dissolution of the resulting polyimide resin becomes difficult, and the viscosity of the resin solution becomes overly high, which can make handling difficult. The weight average molecular weight of the polyimide can be determined using gel permeation chromatography.

The polyimide resin represented by the formula (I) that is included within the adhesive film of the present invention can be obtained by reacting a diamine that comprises a compound represented by the formula (II) shown below, with a tetracarboxylic dianhydride. 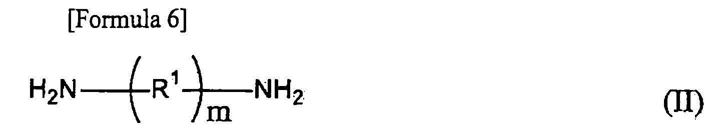 In the formula, the m R¹ groups each represent, independently, a bivalent organic group, and m represents an integer of not less than 8. Of the m R¹ groups, the total number of -CH₂-, -CHR- and -CR₂- groups (wherein, R represents a non-cyclic alkyl group of 1 to 5 carbon atoms) is k, wherein k and m satisfy: k/m ≥ 0.85.
The diamine represented by the formula (II) preferably represents not less than 50 mol%, even more preferably not less than 60 mol%, and most preferably 70 mol% or greater of the total quantity of diamine.

R¹ represents a bivalent organic group, and represents the smallest unit (segment). Specific examples include -CH₂-, CHR-, -CR₂-, -NH-, -CO-, -Ar-, -S- and -SO-. The diamine represented by the formula (II) comprises predominantly -CH₂-, -CHR- and/or -CR₂- groups (hereafter also abbreviated as methylene groups) as the R¹ groups. As a result, the bonding temperature during bonding of a semiconductor element to a supporting member (or to another semiconductor element) using the adhesive film of the present invention can be reduced (to 120 to 160°C), and moreover, an adhesive film with excellent resistance to moisture absorption can be obtained.

In the diamine represented by the above formula (II), the total number m of the bivalent organic groups R¹ and the total number k of methylene groups preferably satisfy the relational formula: k/m ≥ 0.85. If the R¹ groups include a large number of groups besides the methylene groups and k/m < 0.85, then moisture absorption tends to increase, and the reflow crack resistance tends to deteriorate. The value of k/m is even more preferably k/m ≥ 0.90, and is most preferably k/m ≥ 0.95.

Moreover, the R¹ groups preferably include no polar groups or polar atoms (such as oxygen atoms or nitrogen atoms). If the R¹ groups include a large number of polar groups or polar atoms, then moisture absorption tends to increase, and the reflow crack resistance tends to deteriorate.

In order to enable bonding (between a semiconductor element and a support member, or between semiconductor elements, this definition also applies below) at lower temperatures (120 to 160°C) than those conventionally used, m preferably satisfies m ≥ 8, and even more preferably m ≥ 10. Although there are no particular restrictions on the upper limit for the value of m, in terms of ensuring ready availability, m preferably satisfies m ≤ 40. Because the low-temperature bonding properties tend to improve with increasing values of m, the same low-temperature bonding effects can be achieved even with numerical values of m exceeding 40. If the value of m is less than 8, then because the molecular chain length of the resulting polyimide resin (A) shortens for the number of mols of diamine used, the low-temperature bonding effect tends to diminish.

R is a non-cyclic alkyl group of 1 to 5 carbon atoms, and is preferably a linear alkyl group of 1 to 5 carbon atoms. Examples of non-cyclic alkyl groups of 1 to 5 carbon atoms include unsubstituted linear alkyl groups of 1 to 5 carbon atoms and linear alkyl groups of 1 to 5 carbon atoms substituted with an alkyl group of 1 to 3 carbon atoms, and specific examples include a methyl group, ethyl group, n-propyl group, isopropyl group, n-butyl group, isobutyl group, s-butyl group, t-butyl group, n-pentyl group, 1-methylbutyl group, 2-methylbutyl group, 3-methylbutyl group, 1,1-dimethypropyl group, 1,2-dimethylpropyl group, 2,2-dimethylpropyl group, and 1-ethylpropyl group.

Examples of the type of diamine described above include aliphatic diamines such as 1,8-octanediamine (m=k=8), 1,9-nonanediamine (m=k=9), 1,10-decanediamine (m=k=10), 1,11-undecanediamine (m=k=11), 1,12-dodecanediamine (m=k=12), tridecamethylenediamine (m=k=13) and octadecamethylenediamine (m=k=18), and alkyl ethers such as bis(5-aminopentyl) ether (m=11, k=10, k/m = 0.91) and 3,3'-(decamethylenedioxy)bis(propylamine) (m=18, k=16, k/m = 0.89), and of these, the use of an n-alkylenediamine is preferred.

For example, an adhesive film formed using 1,12-dodecanediamine (m=k=12, k/m = 1.0) exhibits clearly superior reliability, and particularly reflow resistance, when compared with an adhesive film formed using the similar structured 1,4-butanediol-bis(3-aminopropyl) ether (wherein, R¹ represents two bivalent groups, namely -CH₂- and -O-, m=12, k=10, and k/m = 0.83), even if the composition of the other components of the film is identical.

Examples of other diamines that may be used in combination with the diamine represented by the formula (II) include aliphatic diamines such as 1,2-diaminoethane, 1,3-diaminopropane, 1,4-diaminobutane and 1,5-diaminopentane, aromatic diamines such as o-phenylenediamine, m-phenylenediamine, p-phenylenediamine, 3,3'-diaminodiphenyl ether, 3,4'-diazninodiphenyl ether, 4,4'-diaminodiphenyl ether, 3,3'-diaminodiphenylmethane, 3,4'-diaminodiphenylinethane, 4,4'-diaminodiphenylmethane, 3,3'-diaminodiphenyldifluoromethane, 3,4'-diaminodiphenyldifluoromethane, 4,4'-diaminodiphenyldifluoromethane, 3,3'-diaminodiphenyl sulfone, 3,4'-diaminodiphenyl sulfone, 4,4'-diaminodiphenyl sulfone, 3,3'-diaminodiphenyl sulfide, 3,4'-diaminodiphenyl sulfide, 4,4'-diaminodiphenyl sulfide, 3,3'-diaminodiphenyl ketone, 3,4'-diaminodiphenyl ketone, 4,4'-diaminodiphenyl ketone, 2,2-bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3-bis(3-aminophenoxy)benzene, 1,4-bis(3-aminophenoxy)benzene, 1,4-bis(4-aminophenoxy)benzene, 3,3'-(1,4-phenylenebis(1-methylethylidene))bisaniline, 3,4'-(1,4-phenylenebis(1-methylethylidene))bisaniline, 4,4'-(1,4-phenylenebis(l -methylethylidene))bisaniline, 2,2-bis(4-(3-aminophenoxy)phenyl)propane, 2,2-bis(4-(4-aminophenoxy)phenyl)propane, 2,2-bis(4-(3-aminophenoxy)phenyl)hexafluoropropane, 2,2-bis(4-(4-aminophenoxy)phenyl)hexafluoropropane, bis(4-(3-aminophenoxy)phenyl) sulfide, bis(4-(4-aminophenoxy)phenyl) sulfide, bis(4-(3-aminophenoxy)phenyl) sulfone, and bis(4-(4-aminophenoxy)phenyl) sulfone, as well as 1,1,3,3-tetramethyl-1,3-bis(4-aminophenyl)disiloxane, 1,1,3,3-tetraphenoxy-1,3-bis(4-aminoethyl)disiloxane, 1,1,3,3-tetraphenyl-1,3-bis(2-aminoethyl)disiloxane, 1,1,3,3-tetraphenyl-1,3-bis(3-aminopropyl)disiloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(3-aminobutyl)disiloxane, 1,3-dimethyl-1,3-dimethoxy-1,3-bis(4-aminobutyl)disiloxane, 1,1,3,3,5,5-hexamethyl-1,5-bis(4-aminophenyl)trisiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisiloxane, 1,1,5,5-tetramethyl-3,3-dimethoxy-1,5-bis(2-aminoethyl)trisiloxane ,1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3,3,5,5-hexaethyl-1,5-bis(3-aminopropyl)trisiloxane and 1,1,3,3,5,5-hexapropyl-1,5-bis(3-aminopropyl)trisiloxane, and these compounds may be used either alone, or in combinations of two or more different compounds.

Furthermore, the diamines represented by the formula (II) include compounds which, upon synthesis of a polyimide resin using the diamines, cause a deterioration in the solubility of the polyimide resin within solvents. Accordingly, by using a suitable supplementary diamine selected in accordance with the nature of the diamine being used, for example, by selecting a diamine with excellent solubility, the solubility of the resulting polyimide resin can be improved, thereby facilitating film production.

Although there are no particular restrictions on the tetracarboxylic dianhydride that functions as a raw material for the polyimide resin, in terms of enhancing the moisture resistance of the resulting adhesive film, the quantity of tetracarboxylic dianhydrides containing no hydrolyzable functional groups is preferably maximized. Specifically, the quantity of tetracarboxylic dianhydrides containing no hydrolyzable functional groups preferably represents not less than 60 mol%, and even more preferably not less than 70 mol%, and most preferably 80 mol% or more, of the total quantity of tetracarboxylic dianhydrides. If this quantity is less than 60 mol%, then decomposition tends to be accelerated in environments in which the temperature exceeds the glass transition temperature and the humidity is high, and depending on the structure of the semiconductor device, the device may be unable to withstand reliability tests such as the HAST test.

Examples of the aforementioned hydrolyzable functional groups include ester groups such as carboxylate esters, and amide groups (-HNCO-, but excluding the amic acids that function as intermediates in imidization reactions).

Examples of tetracarboxylic dianhydrides containing no hydrolyzable functional groups include pyromellitic dianhydride, 3,3',4,4'-diphenyltetracarboxylic dianhydride, 2,2',3,3'-diphenyltetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl) sulfone dianhydride, 3,4,9,10-perylenetetracarboxylic dianhydride, bis(3,4-dicarboxyphenyl) ether dianhydride, benzene-1,2,3,4-tetracarboxylic dianhydride, 3,3',4,4'-benzophenonetetracarboxylic dianhydride, 2,2',3,3'-benzophenonetetracarboxylic dianhydride, 2,3,3',4'-benzophenonetetracarboxylic dianhydride, 1,2,5,6-naphthalenetetracarboxylic dianhydride, 2,3,6,7-naphthalenetetracarboxylic dianhydride, 1,2,4,5-naphthalenetetracarboxylic dianhydride, 1,4,5,8-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,4,5-tetracarboxylic dianhydride, 2,3,3',4'-biphenyltetracarboxylic dianhydride, 3,3',4,4'-biphenyltetracarboxylic dianhydride, 2,2',3,3'-biphenyltetracarboxylic dianhydride, bis(3,4-dicarboxyphenyl)dimethylsilane dianhydride, bis(3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetracarboxylic dianhydride, bicyclo-[2,2,2]-oct-7-ene-2,3,5,6-tetracarboxylic dianhydride, 2,2-bis(3,4-dicarboxyphenyl)hexafluoropropane dianhydride, 2,2-bis(4-(3,4-dicarboxyphenoxy)phenyl)hexafluoropropane dianhydride, 4,4'-bis(3,4-dicarboxyphenoxy)diphenyl sulfide dianhydride, 4,4'-(4,4'-isopropylidenediphenoxy)diphthalic dianhydride, tetrahydrofuran-2,3,4,5-tetracarboxylic dianhydride, and bis(exo-bicyclo[2,2,1]heptane-2,3-dicarboxylic dianhydride) sulfone.

Furthermore, the use of 4,4'-(4,4'-isopropylidenediphenoxy)diphthalic dianhydride represented by the formula (III) shown below as the tetracarboxylic dianhydride described above yields a highly reliable adhesive film with excellent adhesive strength and a favorable balance between the various film properties, and is consequently preferred.

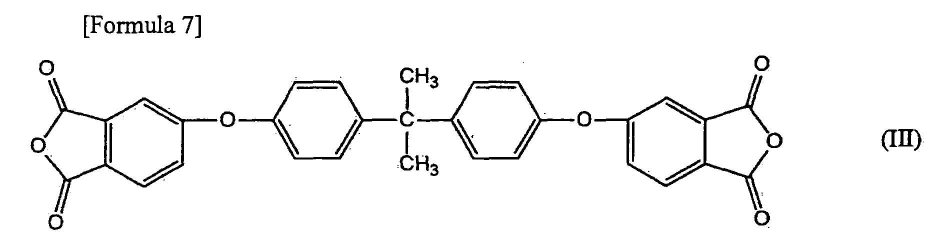

Furthermore, examples of tetracarboxylic dianhydrides include p-phenylenebis(trimellitate) dianhydride, 4,4'-[ethane-1,2-diylbis(oxycarbonyl)]diphthalic dianhydride, 4,4'-[decane-1,10-diylbis(oxycarbonyl)Jdiphthalic dianhydride, 1,4-bis(2-hydroxyhexafluoroisopropyl)benzenebis(trimellitate) dianhydride, 1,3-bis(2-hydroxyhexafluoroisopropyl)benzenebis(trimellitate) dianhydride, 4,4'-[propane-1,3-diylbis(oxycarbonyl)]diphthalic dianhydride, 4,4'-[butane-1,4-diylbis(oxycarbonyl)]diphthalic dianhydride, 4,4'-[pentane-1,5-diylbis(oxycarbonyl)]diphthalic dianhydride, 4,4'-[hexane-1,6-diylbis(oxycarbonyl)]diphthalic dianhydride, 4,4'-[heptane-1,7-diylbis(oxycarbonyl)]diphthalic dianhydride, 4,4'-[octane-1,8-diylbis(oxycarbonyl)]diphthalic dianhydride, 4,4'-[nonane-1,9-diylbis(oxycarbonyl)]diphthalic dianhydride, 4,4'-[undecane-1,11-diylbis(oxycarbonyl)]diphthalic dianhydride, and 4,4'-[dodecane-1,12-diylbis(oxycarbonyl)]diphthalic dianhydride, and these compounds may be used either alone, or in combinations of two or more different compounds. Because these tetracarboxylic dianhydrides include hydrolyzable substituent groups, their use is preferably restricted to a quantity that does not exceed 40 mol% of the total quantity of tetracarboxylic dianhydrides.

The condensation reaction between the tetracarboxylic dianhydride and the diamine is conducted within an organic solvent. In this case, the quantities of the tetracarboxylic dianhydride and the diamine are preferably set such that the quantity of the diamine is within ± 10 mol% from an equimolar quantity relative to the quantity of the tetracarboxylic dianhydride. Furthermore, the order in which each component is added is arbitrary. Examples of organic solvents that can be used during the synthesis include dimethylacetamide, dimethylformamide, N-methyl-2-pyrrolidone, dimethylsulfoxide, hexamethylphosphorylamide, m-cresol, and o-chlorophenol.

The reaction temperature is preferably not higher than 150°C, and is even more preferably within a range from 0 to 120°C. In those cases where the solubility of the diamine represented by the formula (II) is not particularly favorable, it may be preferable to heat the reaction system to a temperature of 50°C or higher in order to obtain a uniform reaction solution. As the reaction progresses, the viscosity of the reaction solution gradually increases. This indicates the generation of a polyamic acid that represents a precursor to the polyimide.

The polyimide can be obtained by a dehydration cyclization of the above polyamic acid. The dehydration cyclization can be conducted using either a method in which a heat treatment is conducted at 120 to 250°C, or a chemical method. In the case of a method in which a heat treatment is conducted at 120 to 250°C, the water generated by the dehydration reaction is preferably removed from the system as the reaction proceeds. In this case, the water may be removed by azeotropic distillation using benzene, toluene, or xylene or the like. In this description, the term polyimide resin is a generic term that includes both the polyimide and precursors thereto. Polyimide precursors include not only polyamic acid, but also materials in which a polyamic acid has undergone partial imidization. The synthesis of the polyamic acid and the dehydration cyclization conducted by heat treatment need not necessarily be separated into distinct steps.

In those cases where a chemical method is used to effect the dehydration cyclization, an acid anhydride such as acetic anhydride, propionic anhydride or benzoic anhydride, or a carbodiimide compound such as dicyclohexylcarbodiimide can be used as a cyclization agent. If required, a cyclization catalyst such as pyridine, isoquinoline, trimethylamine, aminopyridine or imidazole may also be used. The cyclization agent or cyclization catalyst is preferably used in a quantity within a range from 1 to 8 mols per 1 mol of the tetracarboxylic dianhydride.

The synthesized polyimide resin can be obtained as a solid by removing the majority of the solvent used during the reaction. Examples of the method used include methods in which the resin is dried by evaporating the solvent used for the reaction at an appropriate temperature and pressure. Furthermore, another method involves adding the reaction solution to a poor solvent that exhibits a suitably low solubility of the resin, thereby precipitating the resin, subsequently removing the poor solvent and the solvent used for the reaction by filtration or decantation, and then drying the resin. This type of method is preferred as it enables impurities within the resin, and particularly impurities with low volatility, to also be removed from the resin.

Although there are no particular restrictions on the aforementioned poor solvent, provided it exhibits poor solubility of the polyimide resin, from the viewpoint of ease of handling, water or a lower alcohol of not more than 4 carbon atoms is preferred, and these solvents may be used either alone, or in combinations of two or more different solvents. Furthermore, a good solvent may also be mixed into the combined solvent, provided the quantity is such that the resin is still able to be precipitated.

Furthermore, in those cases where the reaction system contains no impurities, or contains sufficiently few impurities as to have no effect on the resin properties, the solvent used for the reaction may be used, as is, as the solvent used in the production of the adhesive film described below. In such cases, there is no need to remove the reaction solvent, meaning the production process can be shortened, which is preferred in terms of the production cost.

The adhesive film of the present invention comprises a thermosetting resin (B) in order to improve the film strength upon heating. There are no particular restrictions on the thermosetting resin (B), and conventional resins can be used. In terms of convenience as a semiconductor peripheral material (namely, in terms of ease of availability of high-purity materials, a wide variety of resins, and readily controllable reactivity), epoxy resins (typically combined with an epoxy resin curing agent) or imide compounds containing at least two thermosetting imide groups within each molecule are preferred.

In those cases where an epoxy resin and an epoxy resin curing agent are used as the thermosetting resin (B), the epoxy resin used preferably comprises at least two epoxy groups within each molecule, and from the viewpoints of curability and the properties of the cured product a phenol glycidyl ether-based epoxy resin is preferred. Specific examples of such resins include condensation products of bisphenol A, bisphenol AD, bisphenol S, bisphenol F or a halogenated bisphenol A with epichlorohydrin, glycidyl ethers of phenol novolak resins, glycidyl ethers of cresol novolak resins, and glycidyl ethers of bisphenol A novolak resins.

Among these epoxy resins, trifunctional or higher epoxy resin are particularly preferred as they yield a larger effect in terms of improving the properties of the film. There are no particular restrictions on these trifunctional or higher epoxy resins, provided they contain at least three epoxy groups within each molecule, and suitable examples include novolak epoxy resins represented by a formula (IV) shown below, trifunctional (or tetrafunctional) glycidyl ethers, and trifunctional (or tetrafunctional) glycidyl amines. 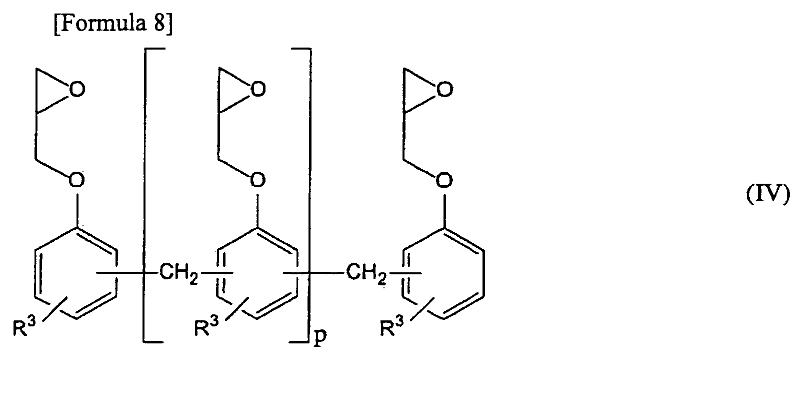 (wherein, each of the plurality of R³ groups represents, independently, a hydrogen atom, an alkyl group of 1 to 5 carbon atoms that may contain a substituent group, or a phenyl group that may contain a substituent group, and p represents an integer from 1 to 20)

Examples of the novolak epoxy resins represented by the above formula (IV) include glycidyl ethers of cresol novolak resins and glycidyl ethers of phenol novolak resins. These resins are preferred as they exhibit a high degree of cross-linking within the cured product, enabling the adhesive strength of the film upon heating to be increased. These resins may be used either alone, or in combinations of two or more different resins.

There are no particular restrictions on the epoxy resin curing agent used in the present invention, and suitable examples include phenol-based compounds, aliphatic amines, alicyclic amines, aromatic polyamines, polyamides, aliphatic acid anhydrides, alicyclic acid anhydrides, aromatic acid anhydrides, dicyandiamide, organic acid dihydrazides, boron trifluoride amine complexes, imidazoles, and tertiary amines. Of these, phenol-based compounds are preferred, and phenol-based compounds having at least two phenolic hydroxyl groups within each molecule are particularly desirable.

Examples of the above phenol-based compounds having at least two phenolic hydroxyl groups within each molecule include phenol novolak resins, cresol novolak resins, t-butylphenol novolak resins, dicyclopentadiene cresol novolak resins, dicyclopentadiene phenol novolak resins, xylylene-modified phenol novolak resins, naphthol novolak resins, trisphenol novolak resins, tetrakisphenol novolak resins, bisphenol A novolak resins, poly-p-vinylphenol resins, and phenol aralkyl resins. Of these, resins with a number average molecular weight within a range from 400 to 1,500 are preferably used. As a result, the generation of out-gas, which can cause contamination of the surface of the semiconductor element or device, can be effectively reduced during the heating that is conducted during package assembly. The number average molecular weight can be determined by gel permeation chromatography.

Among the curing agents exemplified above, in terms of effectively reducing the generation of out-gas, which can cause contamination of the semiconductor element or device during the heating that is conducted during package assembly, and may also cause odors, naphthol novolak resins or trisphenol novolak resins are particularly preferred.

Examples of the above naphthol novolak resins include naphthol-based compounds containing three or more aromatic rings within each molecule represented by a formula (V) and a formula (VI) shown below. 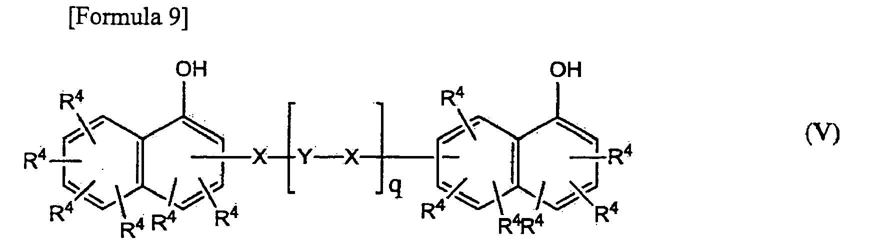 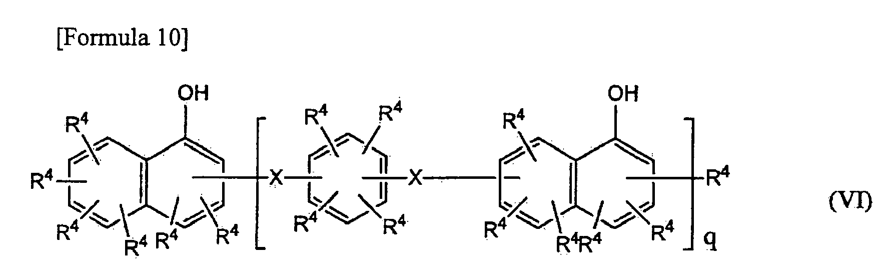 (wherein, each of the plurality of R⁴ groups represents, independently, a hydrogen atom, an alkyl group of 1 to 10 carbon atoms, a phenyl group or a hydroxyl group, q represents an integer from 1 to 10, X represents a bivalent organic group, and Y represents a bivalent organic group selected from groups represented by formulas shown below

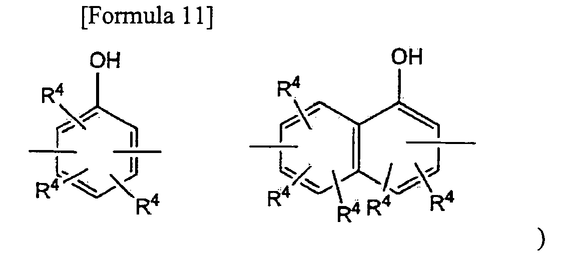

Specific examples of the organic groups X within the above formulas (V) and (VI) include the bivalent organic groups represented by formulas shown below.

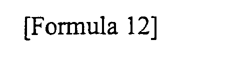

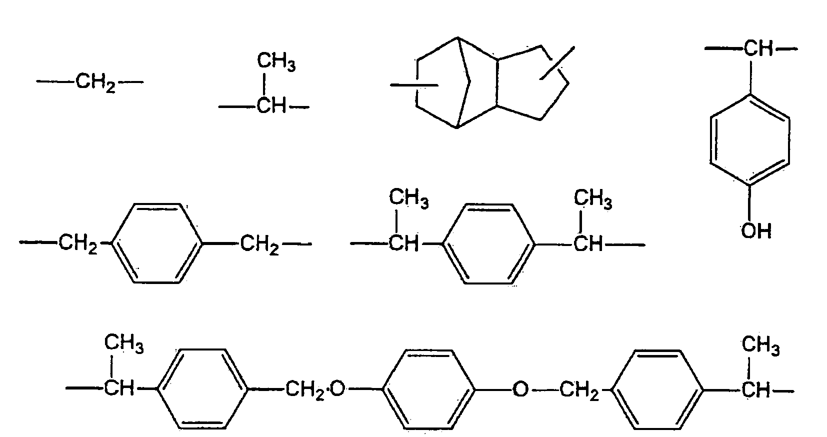

More specific examples of these types of naphthol-based compounds include xylylene-modified naphthol novolak represented by formulas (VII) or (VIII) shown below, and naphthol novolak prepared by condensation with p-cresol, as represented by a formula (IX) shown below. 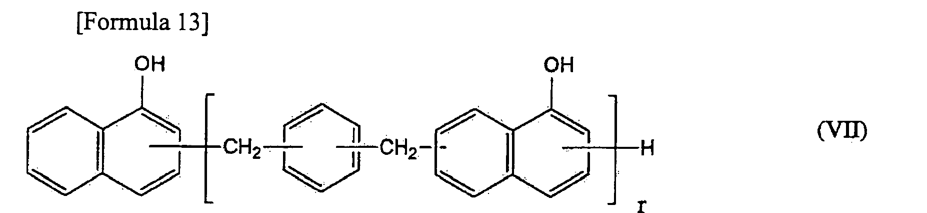 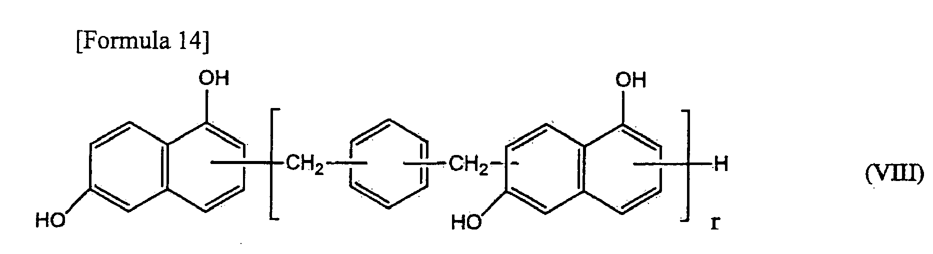 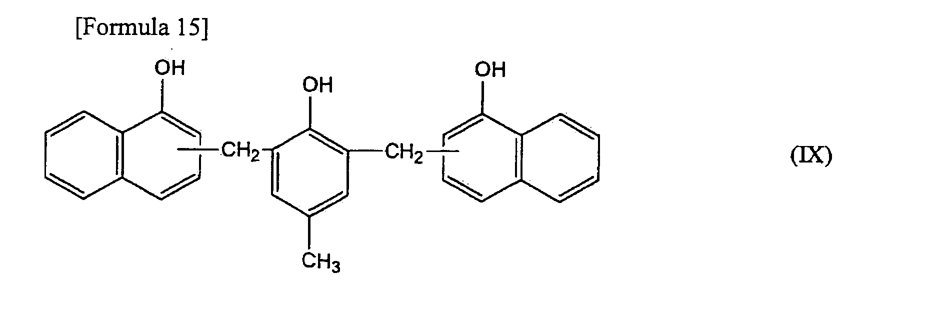 (In the formulas (VII) to (XIII), r represents an integer from 1 to 10.)

Furthermore, the aforementioned trisphenol novolak resins may be any trisphenol-based compound comprising three hydroxyphenyl groups within each molecule, but of such compounds, compounds represented by a formula (X) shown below are preferred. 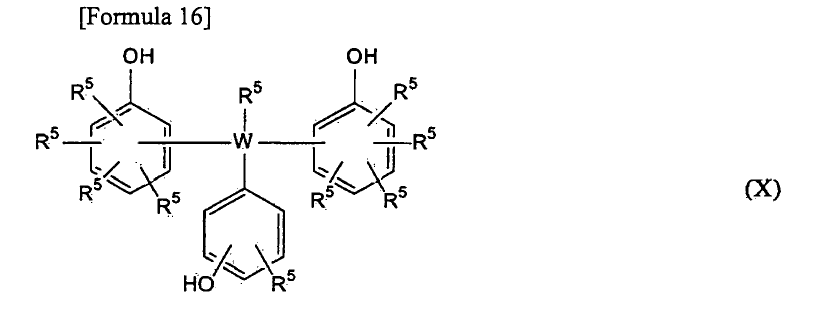 (wherein, each of the plurality of R⁵ groups represents, independently, a group selected from the group consisting of a hydrogen atom, alkyl groups of 1 to 10 carbon atoms, a phenyl group and a hydroxyl group, and W represents a tetravalent organic group selected from groups represented by formulas shown below)

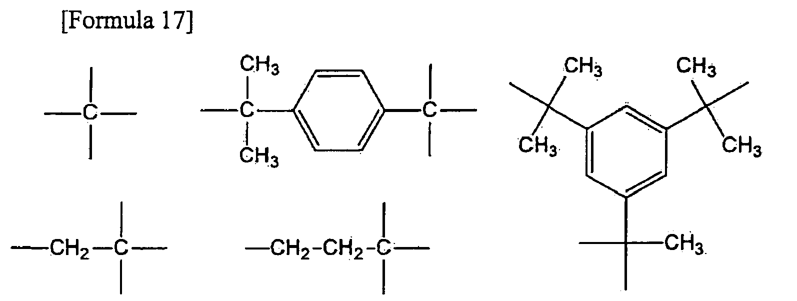

Specific examples of this type of trisphenol-based compound include 4,4',4"-methylidenetrisphenol, 4,4'-[1-[4-[1-(4-hydroxyphenyl)-1-methylethyl]phenyl]ethylidene]bisphenol, 4,4',4"-ethylidinetris[2-methylphenol], 4,4',4"-ethylidinetrisphenol, 4,4'-[(2-hydroxyphenyl)methylene]bis[2-methylphenol], 4,4'-[(4-hydroxyphenyl)methylene]bis[2-methylphenol], 4,4'-[(2-hydroxyphenyl)methylene]bis[2,3-dimethylphenol], 4,4'-[(4-hydroxyphenyl)methylene]bis[2,6-dimethylphenol], 4,4'-[(3-hydroxyphenyl)methylene]bis[2,3-dimethylphenol], 2,2'-[(2-hydroxyphenyl)methylene]bis[3,5-dimethylphenol], 2,2'-[(4-hydroxyphenyl)methylene]bis[3,5-dimethylphenol], 2,2'-[(2-hydroxyphenyl)methylene]bis[2,3,5-trimethylphenol], 4,4'-[(2-hydroxyphenyl)methylene]bis [2,3,6-trimethylphenol], 4,4'-[(3-hydroxyphenyl)methylene]bis[2,3,6-trimethylphenol], 4,4'-[(4-hydroxyphenyl)methylene]bis[2,3,6-trimethylphenol], 4,4'-[(2-hydroxyphenyl)methylene]bis[2-cyclohexyl-5-methylphenol], 4,4'-[(3-hydroxyphenyl)methylene]bis[2-cyclohexyl-5-methylphenol], 4,4'-[(4-hydroxyphenyl)methylene]bis[2-cyclohexyl-S-methylphenol], 4,4'-[(3,4-dihydroxyphenyl)methylene]bis[2-methylphenol], 4,4'-[(3,4-dihydroxyphenyl)methylene]bis[2,6-dimethylphenol], 4,4'-[(3,4-dihydroxyphenyl)methylene]bis[2,3,6-trimethylphenol], 4-[bis(3-cyclohexyl-4-hydroxy-6-methylphenyl)methyl]-1,2-benzenediol, 4,4'-[(2-hydroxyphenyl)methylene]bis[3-methylphenol], 4,4',4"-(3-methyl-1-propanyl-3-ylidene)trisphenol, 4,4'-[(2-hydroxyphenyl)methylene]bis[2-methylethylphenol], 4,4'-[(3-hydroxyphenyl)methylene]bis[2-methylethylphenol], 4,4'-[(4-hydroxyphenyl)methylene]bis[2-methylethylphenol], 2,2'-[(3-hydroxyphenyl)methylene]bis[3,5,6-trimethylphenol], 2,2'-[(4-hydroxyphenyl)methylene]bis[3,5,6-trimethylphenol], 4,4'-[(2-hydroxyphenyl)methylene]bis[2-cyclohexylphenol], 4,4'-[(3-hydroxyphenyl)methylene]bis[2-cyclohexylphenol], 4,4'-[1-[4-[1-(4-hydroxy-3,5-dimethylphenyl)-1-methylethyl]phenyl] ethylidene]bis[2,6-dimethylphenol], 4,4',4"-methylidynetris[2-cyclohexyl-5-methylphenol], 4,4'-[1-[4-[1-(3-cyclohexyl-4-hydroxyphenyl)-1-methylethyl]phenyl]ethylidene]bis[2-cyclohexylphenol], 2,2'-[(3,4-dihydroxyphenyl)methylene]bis[3,5-dimethylphenol], 4,4'-[(3,4-dihydroxyphenyl)methylene]bis[2-(methylethyl)phenol], 2,2'-[3,4-dihydroxyphenyl)methylene]bis[3,5,6-trimethylphenyl], 4,4'-[(3,4-dihydroxyphenyl)methylene]bis[2-cyclohexylphenol] and α,α',α"-tris(4-hydroxyphenyl)-1,3,5-triisopropylbenzene. These compounds may be used either alone, or in combinations of two or more different compounds.

In those cases where a thermosetting resin comprising an epoxy resin and an epoxy resin curing agent is used as the thermosetting resin (B), the quantity of the epoxy resin is preferably within a range from 1 to 200 parts by weight, even more preferably from 1 to 100 parts by weight, even more preferably from 1 to 90 parts by weight, even more preferably from 2 to 80 parts by weight, and most preferably from 2 to 50 parts by weight, per 100 parts by weight of the polyimide resin (A). If this quantity exceeds 200 parts by weight, then the film-forming properties tend to deteriorate. If the quantity is less than 1 part by weight, then the storage elastic modulus tends to decrease.

Furthermore, the quantity of the epoxy resin curing agent is preferably within a range from 0.1 to 150 parts by weight, even more preferably from 0.1 to 120 parts by weight, even more preferably from 10 to 100 parts by weight, and is most preferably from 20 to 100 parts by weight, per 100 parts by weight of the epoxy resin. If this quantity exceeds 150 parts by weight, then the curability tends to be inadequate. If the quantity is less than 0.1 parts by weight, then the storage elastic modulus tends to decrease.

Furthermore, a curing accelerator may also be used in combination with the epoxy resin. The curing accelerator may be any material used for curing epoxy resins. Specific examples of suitable materials include imidazoles, dicyandiamide derivatives, dicarboxylic acid dihydrazides, triphenylphosphine, tetraphenylphosphonium tetraphenylborate, 2-ethyl-4-methylimidazole tetraphenylborate, and 1,8-diazabicyclo(5.4.0)undecene-7-tetraphenylborate. These compounds may be used either alone, or in combinations of two or more different compounds.

The quantity of the curing accelerator is preferably within a range from 0.01 to 50 parts by weight, even more preferably from 0.01 to 20 parts by weight, and most preferably from 0.1 to 10 parts by weight, per 100 parts by weight of the epoxy resin. If this quantity exceeds 50 parts by weight, then the storage stability tends to deteriorate. If the quantity is less than 0.01 parts by weight, then the effect of the curing accelerator tends to be inadequate.

In those cases where an imide compound containing at least two thermosetting imide groups within each molecule is selected as the thermosetting resin, suitable examples of such compounds include orthobismaleimidobenzene, metabismaleimidobenzene, parabismaleimidobenzene, 1,4-bis(p-maleimidocumyl)benzene and 1,4-bis(m-maleimidocumyl)benzene.

Furthermore, other suitable compounds include the imide compounds represented by formulas (XI) through (XIV) shown below, and any of these compounds may be used either alone, or in combinations of two or more different compounds.

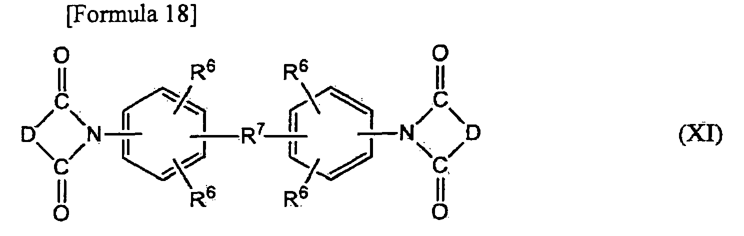

(wherein, R⁷ represents -O-, -CH₂-, -CF₂-, -SO₂- -S-, -CO-, -C(CH₃)₂- or -C(CF₃)₂-, each of the four R⁶ groups represents, independently, a hydrogen atom, an alkyl group of 1 to 6 carbon atoms, an alkoxy group of 1 to 6 carbon atoms, or a fluorine atom, chlorine atom or bromine atom, and D represents a dicarboxylic acid residue containing an ethylenic unsaturated double bond)

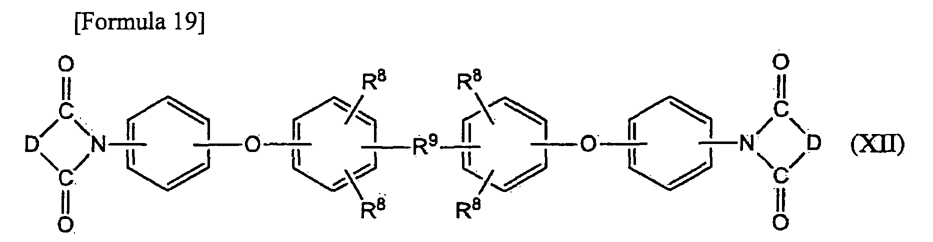

(wherein, R⁹ represents -O-, -CH₂-, -CF₂-, -SO₂-, -S-, -CO-, -C(CH₃)₂- or -C(CF₃)₂-, each of the four R⁸ groups represents, independently, a hydrogen atom, an alkyl group of 1 to 6 carbon atoms, an alkoxy group of 1 to 6 carbon atoms, or a fluorine atom, chlorine atom or bromine atom, and D represents a dicarboxylic acid residue containing an ethylenic unsaturated double bond)

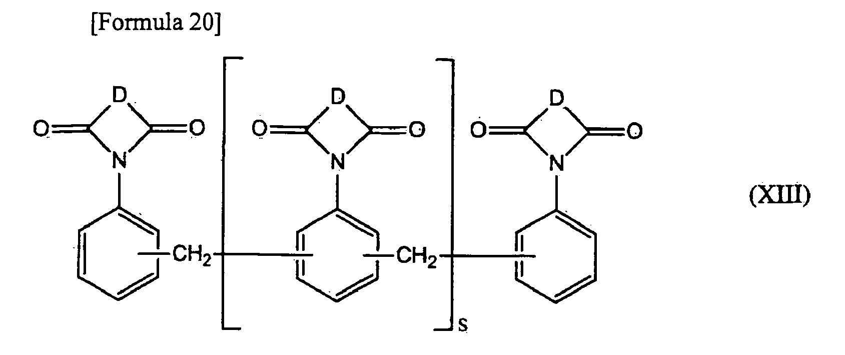

(wherein, s represents an integer from 0 to 4, and D represents a dicarboxylic acid residue containing an ethylenic unsaturated double bond)

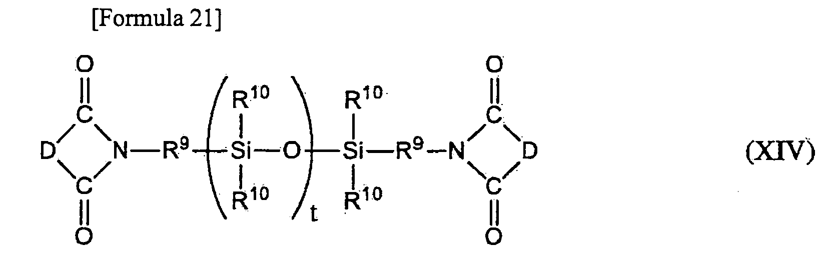

(wherein, each of the two R⁹ groups represents, independently, a bivalent hydrocarbon group, each of the plurality of R¹⁰ groups represents, independently, a monovalent hydrocarbon group, D represents a dicarboxylic acid residue containing an ethylenic unsaturated double bond, and t represents an integer of 1 or greater)

In each of the above formulas, examples of the dicarboxylic acid residue containing an ethylenic unsaturated double bond represented by D include a maleic acid residue or a citraconic acid residue.

The quantity of the imide compound used in the present invention is preferably within a range from 0.1 to 200 parts by weight, even more preferably from 0.5 to 150 parts by weight, even more preferably from 1 to 100 parts by weight, even more preferably from 2 to 70 parts by weight, and is most preferably from 5 to 50 parts by weight, per 100 parts by weight of the polyimide resin (A). If this quantity exceeds 200 parts by weight, then the film-forming properties tend to deteriorate. If the quantity is less than 0.1 parts by weight, then the storage elastic modulus at high temperatures tend to decrease.

Specific examples of the imide compounds represented by the above formula (XI) include 4,4-bismaleimidodiphenyl ether, 4,4-bismaleimidodiphenylmethane, 4,4-bismaleimido-3,3'-dimethyldiphenylmethane, 4,4-bismaleimidodiphenyl sulfone, 4,4-bismaleimidodiphenyl sulfide, 4,4-bismaleimidodiphenyl ketone, 2,2'-bis(4-maleimidophenyl)propane, 4,4-bismaleimidodiphenylfluoromethane, and 1,1,1,3,3,3,-hexafluoro-2,2-bis(4-maleimidophenyl)propane.

Specific examples of the imide compounds represented by the above formula (XII) include bis(4-(4-maleimidophenoxy)phenyl) ether, bis(4-(4-maleimidophenoxy)phenyl)methane, bis(4-(4-maleimidophenoxy)phenyl)fluoromethane, bis(4-(4-maleimidophenoxy)phenyl) sulfone, bis(4-(3-maleimidophenoxy)phenyl) sulfone, bis(4-(4-maleimidophenoxy)phenyl) sulfide, bis(4-(4-maleimidophenoxy)phenyl) ketone, 2,2-bis(4-(4-maleimidophenoxy)phenyl)propane, and 1,1,1,3,3,3-hexafluoro-2,2-bis(4-(4-maleimidophenoxy)phenyl)propane.

In order to accelerate the curing of these imide compounds, a radical polymerization agent may be used. Examples of suitable radical polymerization agents include acetylcyclohexylsulfonyl peroxide, isobutyryl peroxide, benzoyl peroxide, octanoyl peroxide, acetyl peroxide, dicumyl peroxide, cumene hydroperoxide and azobisisobutyronitrile. The quantity used of the radical polymerization agent is preferably within a range from 0.01 to 1.0 parts by weight per 100 parts by weight of the imide compound.

An adhesive film comprising a thermosetting resin (B) exhibits improved shear adhesive strength upon heating, and an improved storage elastic modulus upon heating. Furthermore, an adhesive film comprising the thermosetting resin (B) exhibits increased moisture absorption, and in some cases the peel adhesive strength upon heating may decrease. Accordingly, the quantity of the thermosetting resin is preferably controlled in accordance with the intended application. In the present invention, the thermosetting resin describes a resin that cures and forms a three dimensional network structure upon heating.

The adhesive film of the present invention may also include a filler (C) if required. There are no particular restrictions on the filler, and examples of suitable fillers include metal fillers such as silver powder, gold powder, copper powder and nickel powder, inorganic fillers such as alumina, aluminum hydroxide, magnesium hydroxide, calcium carbonate, magnesium carbonate, calcium silicate, magnesium silicate, calcium oxide, magnesium oxide, aluminum oxide, aluminum nitride, crystalline silica, amorphous silica, boron nitride, titania, glass, iron oxide and ceramics, organic fillers such as carbon, rubber-based fillers and polymer-based fillers, as well as composite fillers including metals and inorganic or organic fillers that have been surface-coated with a metal, and metals and inorganic or organic fillers that have been surface-coated with an organic compound. There are no particular restrictions on the shape of the filler particles.

The above fillers (C) can be selected in accordance with the functions required. For example, metal fillers are added to the adhesive film or the adhesive composition used during formation of the adhesive film for the purposes of imparting conductivity, thermal conductivity, thixotropic properties, adhesiveness, toughness, and a high elastic modulus. Non-metallic inorganic fillers are added for the purposes of imparting thermal conductivity, low thermal expansion properties, low moisture absorption properties, adhesiveness, toughness, and a high elastic modulus. Organic fillers are added for the purpose of imparting toughness and the like. These metal fillers, inorganic fillers, organic fillers or composite fillers may be used either alone, or in combinations of two or more different fillers. An appropriate filler can be selected from among these metal fillers, inorganic fillers, organic fillers and composite fillers order to impart the particular properties required by the semiconductor device. Depending on the semiconductor device, the use of an insulating filler may be desirable, and of the various possible insulating fillers, boron nitride is particularly preferred as it exhibits favorable dispersibility within resin varnishes, and is effective in improving the adhesive strength.

The average particle size of the above filler is preferably not more than 10 µm with a maximum particle size of not more than 25 µm, and the average particle size is even more preferably not more than 5 µm with a maximum particle size of not more than 20 µm. If the average particle size exceeds 10 µm and the maximum particle size exceeds 25 µm, then the effect of the filler in improving the fracture toughness may be unobtainable. Although there are no particular restrictions on the lower limit for the average particle size and the maximum particle size, a value of 0.1 µm is typical for both.

The filler preferably satisfies both the requirements for an average particle size of not more than 10 µm and a maximum particle size of not more than 25 µm. If a filler is used for which the maximum particle size is not more than 25 µm but the average particle size exceeds 10 µm, then a high degree of adhesive strength tends to be unobtainable. Furthermore, in contrast, if a filler is used for which the average particle size is not more than 10 µm but the maximum particle size exceeds 25 µm, then the particle size distribution broadens, and the adhesive strength tends to be prone to fluctuation. Furthermore, when the adhesive composition is formed as a thin film, the surface tends to be rougher, causing a deterioration in the adhesive strength.

The average particle size and maximum particle size of the filler can be measured, for example, using a scanning electron microscope (SEM), by measuring the particle sizes of approximately 200 particles of the filler.

An example of a suitable measurement method using a SEM is a method in which a sample is prepared by using the adhesive composition to bond a semiconductor element to a support substrate and subsequently conducting heat curing (preferably by heating at 150 to 200°C for 1 to 10 hours), and the central portion of this sample is then cut and the resulting cross-section is inspected using the SEM.

Furthermore, in those cases where the filler used is a metal filler or an inorganic filler, another measurement method which involves heating the adhesive composition in an oven at 600°C for 2 hours, thereby decomposing and volatilizing the resin components, and then inspecting and measuring the remaining filler using an SEM can be used.
When the filler itself is inspected using an SEM, a sample is prepared by sticking a double-sided adhesive tape to the sample stage for SEM observation, sprinkling the filler onto the adhesive tape, and then conducting vapor deposition by ion sputtering.
At this time, the existence probability of the aforementioned filler is preferably 80% or more of the entire filler.

The quantity of the above filler (C) can be determined in accordance with the nature of the filler being used, and the properties and functions imparted by the filler, but is preferably within a range from 1 to 8,000 parts by weight, even more preferably from 1 to 5,000 parts by weight, and is most preferably from 1 to 3,000 parts by weight, per 100 parts by weight of the polyimide resin (A). If the quantity is less than 1 part by weight, then the properties and functions imparted as a result of adding the filler may be unobtainable, whereas if the quantity exceeds 8,000 parts by weight, then the adhesion tends to deteriorate.

Furthermore, in order to improve the adhesive strength, the adhesive film of the present invention may further comprise additives such as silane coupling agents, titanium-based coupling agents, nonionic surfactants, fluorine-based surfactants and silicone-based surfactants.

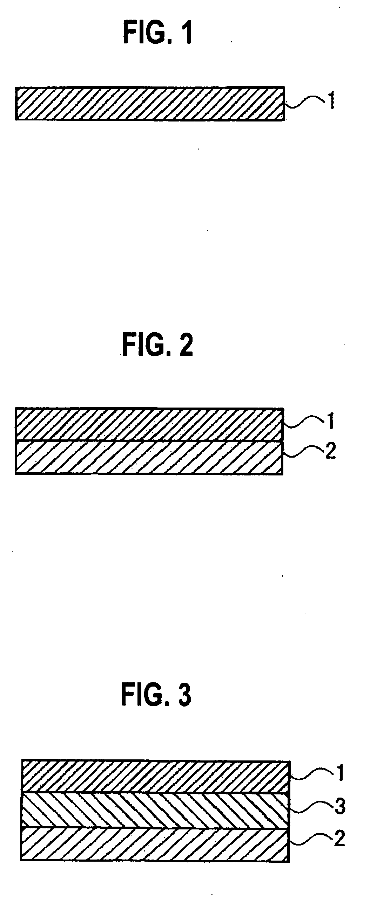

The adhesive film of the present invention can be prepared, for example, as a single layer adhesive film such as that shown in Fig. 1. The adhesive film 1 shown in Fig. 1 can be obtained by first mixing, kneading or dispersing the polyimide resin represented by the formula (I), the thermosetting resin, and if required any of the aforementioned optional components using an organic solvent, thereby preparing a coating varnish, subsequently forming a layer of this coating varnish on top of a base film, conducting heating and drying of the layer, and then removing the base film. For the mixing, kneading or dispersion described above, a typical stirring device and a dispersion device such as a stone mill, three-roll mill, ball mill or homogenizer may be used either alone, or in combinations of two or more different devices. There are no particular restrictions on the conditions employed during the above heating and drying step, provided the solvent being used can be satisfactorily volatilized, and typical conditions involve heating at 50 to 200°C for a period of 0.1 to 90 minutes, with heating at 70 to 200°C for a period of 1 to 90 minutes being preferred in terms of improving the elastic modulus.
There are no particular restrictions on the thickness of the adhesive film following drying, although the dried thickness is preferably within a range from 1 to 200 µm, and even more preferably from 3 to 150 µm.

There are no particular restrictions on the organic solvent, provided it is able to uniformly dissolve, mix or disperse the materials, and examples of suitable solvents include dimethylformamide, dimethylacetamide, N-methylpyrrolidone, dimethylsulfoxide, diethylene glycol dimethyl ether, toluene, benzene, xylene, methyl ethyl ketone, tetrahydrofuran, ethyl cellosolve, ethyl cellosolve acetate, butyl cellosolve, dioxane, cyclohexanone and ethyl acetate, and these solvents may be used either alone, or in combinations of two or more different solvents.

There are no particular restrictions on the base film, provided it is able to withstand the heating and drying conditions described above. Examples of suitable base films include polyester films, polypropylene films, polyethylene terephthalate films, polyimide films, polyetherimide films, polyether naphthalate films, and methylpentene films. The base film may also be a multilayered film comprising a combination of two or more of these films. Furthermore, the surface of the base film may be treated with a release agent such as a silicone-based or silica-based release agent. As shown in Fig. 2, a base film 2 may be left attached to the adhesive film 1 as a support for the adhesive film, thereby forming an adhesive film with an attached base film.

Furthermore, as shown in Fig. 3, the adhesive film of the present invention may also be bonded to a dicing tape comprising a base film layer 2 and a pressure-sensitive adhesive layer 3, thereby forming a single sheet. By layering a dicing sheet and the adhesive film together in advance in this manner, the semiconductor device production process can be simplified.

The obtained adhesive film can be used as the adhesive for bonding semiconductor elements such as ICs and LSIs to the support members used for mounting those semiconductor elements. Furthermore, depending on the nature of the package, the obtained adhesive film can also be used as the adhesive for bonding together semiconductor elements. Examples of suitable support members include lead frames such as 42-alloy lead frames or copper lead frames, plastic films formed from epoxy resins, polyimide resins or maleimide resins, unwoven glass fabric base substrates that have been impregnated with a plastic such as an epoxy resin, polyimide resin or maleimide resin that has subsequently been cured, glass substrates, and ceramic substrates such as alumina substrates.

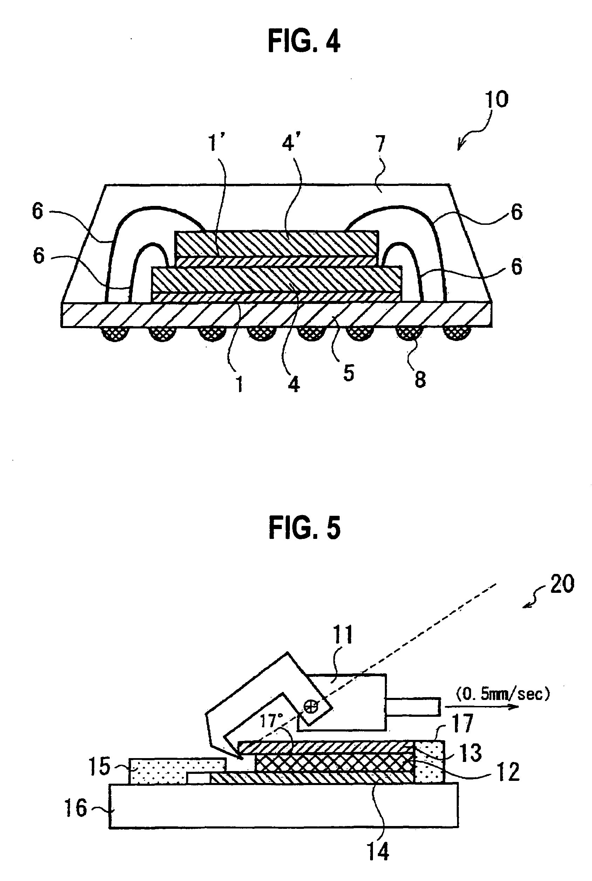

Fig. 4 shows the structure of a semiconductor device 10 that represents one example of a method of using the adhesive film of the present invention. This semiconductor device has a structure in which a plurality of semiconductor elements have been mounted in a stacked arrangement. In other words, in Fig. 4, a first stage semiconductor element 4 is bonded to a semiconductor element support member 5 via an adhesive film 1 of the present invention. In addition, a second stage semiconductor element 4' is then bonded to the top of the first stage semiconductor element 4 via another adhesive film 1' of the present invention. The terminals (not shown in the figure) of the first stage semiconductor element 4 and the second stage semiconductor element 4' are connected electrically to external connection terminals (not shown in the figure) via wiring 6. The entire structure is encapsulated using an encapsulating material 7. In this manner, the adhesive film of the present invention can also be used favorably within semiconductor devices having structures in which a plurality of semiconductor elements are provided in a stacked arrangement.

The semiconductor element and the support member, or the two semiconductor elements, can be bonded together by sandwiching the adhesive film of the present invention between the semiconductor element and the support member, or between the two semiconductor elements, and subsequently conducting heating, typically at a temperature within a range from 60 to 300°C for a period of 0.1 to 300 seconds, and preferably at a temperature of 120 to 200°C for a period of 0.2 to 200 seconds. Furthermore, a loading is preferably applied during bonding, and this loading is preferably within a range from 0.0005 to 1 MPa, and even more preferably from 0.001 to 0.5 MPa.

An adhesive film of the present invention comprising a thermosetting resin is preferably heated following bonding to the semiconductor element, thereby promoting curing and adhesion to the adhesion target, and increasing the strength of the bonded portion. The heating used at this point is typically at a temperature within a range from 60 to 220°C for a period of 0.1 to 600 minutes, and is preferably at a temperature from 120 to 200°C for a period of 0.3 to 120 minutes, although appropriate conditions can be selected in accordance with the nature of the adhesive film. In those cases where resin encapsulation is conducted, the heating conducted during the curing step for the resin used in the encapsulation may be used for the above heating.

The adhesive film of the present invention can be used with a wide variety of substrates, exhibits excellent stability under conditions of high temperature and high humidity, and has a high level of adhesive strength. Consequently, it can be used favorably in next-generation semiconductor packaging techniques that employ insulating support substrates. A semiconductor device produced using this adhesive film exhibits excellent adhesion at high temperature, as well as superior PCT resistance and reflow resistance.

### EXAMPLES

As follows is a description of the present invention based on examples, although the present invention is in no way limited by the examples presented below.

### Synthesis Example 1

A 500 ml four-necked flask fitted with a thermometer, a stirrer, and a calcium chloride tube was charged with 1,12-diaminododecane (0.08 mols) and 1,1,3,3-tetramethyl-1,3-bis(3-aminopropyl)disiloxane (0.02 mols) as the diamine, 150 g of N-methyl-2-pyrrolidone was added as a solvent, and the mixture was stirred at 60°C to dissolve the diamine. Following dissolution of the diamine, 4,4'-(4,4'-isopropylidenediphenoxy)diphthalic dianhydride (0.08 mols) and 4,4'-[decane-1,10-diylbis(oxycarbonyl)]diphthalic dianhydride (0.02 mols) as the tetracarboxylic dianhydride were added gradually in small portions to the diamine solution. Subsequently, the solution was reacted at 60°C for one hour, and was then heated to 170°C under a stream of nitrogen gas, while water was removed via azeotropic distillation with a portion of the solvent. As a result, a polyimide resin (A1) was obtained as a solution.

### Synthesis Example 2

With the exception of using 4,4'-oxydiphthalic dianhydride (0.08 mols) instead of the 4,4'-(4,4'-isopropylidenediphenoxy)diphthalic dianhydride (0.08 mols) from the synthesis example 1, a polyimide resin (A2) was obtained using the same procedure as the synthesis example 1.

### Synthesis Example 3

With the exception of using 4,4'-(4,4'-isopropylidenediphenoxy)diphthalic dianhydride (0.06 mols) and 4,4'-[decane-1,10-diylbis(oxycarbonyl)]diphthalic dianhydride (0.04 mols) as the tetracarboxylic dianhydride, a polyimide resin (A3) was obtained using the same procedure as the synthesis example 1.

### Synthesis Example 4

With the exceptions of using 2,2-bis(4-(4-aminophenoxy)phenyl)propane (0.1 mols) as the diamine and 4,4'-[decane-1,10-diylbis(oxycarbonyl)]diphthalic dianhydride (0.1 mols) as the tetracarboxylic dianhydride, and conducting the dissolution of the raw materials at room temperature, a polyimide resin (A4) was obtained using the same procedure as the synthesis example 1.

### Synthesis Example 5

With the exception of using 2,2-bis(4-(4-aminophenoxy)phenyl)propane (0.05 mols) and 1,4-butanediolbis(3-aminopropyl) ether (0.05 mols) as the diamine, a polyimide resin (A5) was obtained using the same procedure as the synthesis example 4.

### Synthesis Example 6

With the exception of using 1,4-butanediolbis(3-aminopropyl) ether (0.08 mols) instead of the 1,12-diaminododecane (0.08 mols) from the synthesis example 1, a polyimide resin (A6) was obtained using the same procedure as the synthesis example 1.

The values of m and k for the above diamines are as shown below.
(1) 1,12-diaminododecane: m=12, k=12, k/m = 1.0
(2) 1,1,3,3-tetramethyl-1,3-bis(3-aminopropyl)disiloxane: m=9, k=6, k/m = 0.67
(3) 2,2-bis(4-(4-aminophenoxy)phenyl)propane: m=7, k=1, k/m = 0.14
(4) 1,4-butanediolbis(3-aminopropyl) ether: m=12, k=10, k/m = 0.83

Adhesive films of examples 1 to 4 and comparative examples 1 to 4 were obtained using the resins (A1) to (A6) of the synthesis examples, by preparing a varnish in the manner described below, and then molding the varnish into a film. In the following description, "parts" refers to "parts by weight".

### (Example 1)

To 100 parts of the polyimide resin of the synthesis example 1 (calculated as the solid fraction within the N-methyl-2-pyrrolidone solution) were added 9 parts of a cresol novolak epoxy resin (YDCN-702, manufactured by Tohto Kasei Co., Ltd.), 4.5 parts of 4,4'-[1-[4-[1-(4-hydroxyphenyl)-1-methylethyl]phenyl]ethylidene]bisphenol (Tris-P-PA, manufactured by Honshu Chemical Industry Co., Ltd.), 0.75 parts of tetraphenylphosphonium tetraphenylborate (TPPK, manufactured by Tokyo Chemical Industry Co., Ltd.), and 15 parts of a boron nitride filler (HP-P1, manufactured by Mizushima Ferroalloy Co., Ltd), and the resulting mixture was kneaded thoroughly, yielding a varnish B7.

The thus prepared varnish B7 was applied to a polyethylene terephthalate film that had undergone a release treatment, and was then heated at 80°C for 10 minutes and then at 130°C for 10 minutes using a chamber dryer. Subsequently, the polyethylene terephthalate film was peeled off and removed at room temperature, yielding an adhesive film of the example 1 with a thickness of 25 ± 5 µm.

### (Example 2)

Furthermore, the same varnish B7 was applied to a polyethylene terephthalate film that had undergone a release treatment, and was then heated at 80°C for 10 minutes and then at 150°C for 20 minutes using a chamber dryer. Subsequently, the polyethylene terephthalate film was peeled off and removed at room temperature, yielding an adhesive film of the example 2 with a thickness of 25 ± 5 µm.

### (Examples 3 to 4, Comparative Examples 1 to 4)

To 100 part samples of each of the polyimide resins obtained in the synthesis examples 1 to 6 (calculated as the solid fraction within the N-methyl-2-pyrrolidone solution) were added 6 parts of a cresol novolak epoxy resin (YDCN-702, manufactured by Tohto Kasei Co., Ltd.), 3 parts of 4,4'-[1-[4-[1-(4-hydroxyphenyl)-1-methylethyl]phenyl]ethylidene]bisphenol (Tris-P-PA, manufactured by Honshu Chemical Industry Co., Ltd.), 0.5 parts of tetraphenylphosphonium tetraphenylborate (TPPK, manufactured by Tokyo Chemical Industry Co., Ltd.), and 10 parts of a boron nitride filler (HP-P1, manufactured by Mizushima Ferroalloy Co., Ltd), and in each case the resulting mixture was kneaded thoroughly, yielding a series of varnishes B 1 to B6.

Each of the thus prepared varnishes B 1 to B6 was applied to a polyethylene terephthalate film that had undergone a release treatment, and was then heated at 80°C for 10 minutes and then at 130°C for 10 minutes using a chamber dryer. Subsequently, the polyethylene terephthalate film was peeled off and removed at room temperature, yielding a series of adhesive films of the examples 3 and 4 and the comparative examples 1 to 4, each with a thickness of 25 ± 5 µm.

### (Evaluation and Testing)

Each of the adhesive films obtained in the examples 1 to 4 and the comparative examples 1 to 4 was evaluated for reliability and peel adhesive strength, and the storage elastic modulus upon heating following heat treatment was measured.

**[Table 1]**

| Example No. | Polyimide | Varnish | PCT resistance (hours) | Reflow resistance (QFP, JEDEC level) | Peel strength (kgf/chip) | Elastic modulus after heat treatment (250°C) (MPa) |
|---|---|---|---|---|---|---|
| Example 1 | A1 | B7 | > 1,000 | 1 | 1.1 | 1.3 |
| Example 2 | A1 | B7 | > 1,000 | 1 | 1.0 | 1.0 |
| Comparative example 1 | A1 | B1 | > 1,000 | 1 | 1.0 | 0.1 |
| Example 3 | A2 | B2 | > 500 | 2 | 0.8 | 1.0 |
| Example 4 | A3 | B3 | > 350 | 2 | 0.8 | 0.8 |
| Comparative example 2 | A4 | B4 | > 500 | not measurable | did not bond | |
| Comparative example 3 | A5 | B5 | < 100 | 3 | 0.7 | |
| Comparative example 4 | A6 | B6 | > 500 | 3 | 0.6 | |

The methods of conducting the reliability evaluations and the peel strength measurement are described below.

### (Measurement of PCT Resistance)

An adhesive film sample cut to a size of 8 mm × 10 mm was sandwiched between a silicon chip of dimensions 8 mm × 10 mm × 0.4 mm and a lead frame containing a through hole with a diameter of 0.8 mm, and compression bonding was then conducted at 160°C for 5 seconds using a loading of 500 gf/chip, thereby die bonding the silicon chip to the lead frame. Subsequently, the adhesive film was post-cured by heating at 180°C for 60 minutes, and was then treated for a predetermined time period with saturated PCT under conditions of 121°C / 2 atmospheres / 100% humidity. Following this treatment, the surface state of the adhesive film was inspected through the through hole within the lead frame, and the longest treatment time for which no change could be detected in the external appearance was recorded as the PCT resistance value. Here, a change in the external appearance refers to any change in the physical shape that can be detected visually, such as external bleeding of film components, surface roughening, swelling, cracking, pinhole formation, bulging or peeling. In the present invention, provided there were no detectable changes in the above physical shape properties, variations that were limited to changes in the hue or coloring were not recorded as external appearance changes.

### (Measurement of QFP Reflow Resistance)

An adhesive film of 8 mm × 10 mm was sandwiched between a silicon chip of dimensions 8 mm × 10 mm × 0.4 mm and a QFP copper lead frame, and compression bonding was then conducted at 160°C for 5 seconds using a loading of 500 gf/chip, thereby die bonding the silicon chip to the lead frame. Subsequently, the entire structure was subjected to transfer molding using an encapsulating material, and the encapsulating material was then cured by heating at 180°C for 4 hours, thus forming a semiconductor device.
This semiconductor device was subjected to moisture absorption under predetermined moisture absorption conditions prescribed by JEDEC, and was then passed three times through an IR reflow apparatus manufactured by Tamura Corporation (semiconductor device surface peak temperature: 265°C, temperature profile: adjusted in accordance with the JEDEC standard, based on the semiconductor device surface temperature). Subsequently, the semiconductor device was inspected both under the naked eye and using a dial gauge, and the most severe moisture absorption conditions that resulted in no detectable package damage, thickness variation or interface peeling or the like was recorded as the reflow resistance level.
The predetermined moisture absorption conditions prescribed by JEDEC are as follows. Namely, conditions wherein the package was subjected to moisture absorption treatment for 192 hours inside a thermo-hygrostat set to a temperature of 30°C and a humidity of 60% was termed level 3. Similarly, treatment for 168 hours at a temperature of 85°C and a humidity of 60% was termed level 2, and treatment for 168 hours at a temperature of 85°C and a humidity of 85% was termed level 1.

### (Measurement of Peel Strength: Chip Peel Strength)

An adhesive film sample of 5 mm × 3 mm was sandwiched between a silicon chip of dimensions 4 mm × 2 mm × 0.4 mm and a 42-alloy lead frame, and compression bonding was then conducted at 160°C for 5 seconds using a loading of 500 gf/chip, thereby die bonding the silicon chip to the lead frame. Subsequently, the adhesive film was post-cured by heating at 180°C for 60 minutes, and then at 260°C for 20 seconds. The post-heating chip peel strength, with peeling conducted from the 4 mm edge of the chip, was measured using an apparatus shown in Fig. 5 comprising an improved push-pull gauge. This apparatus enables the measurement of the surface contact strength of the adhesive, and as the numerical value for this strength property increases, the occurrence of reflow cracking becomes less likely. The peel strength measuring apparatus 20 shown in Fig. 5 is an apparatus in which a grab handle is provided at the tip of a rod fitted to a push-pull gauge 11, and the angle of the grab handle is able to vary around a fulcrum. In Fig. 20, numeral 12 represents the adhesive film, numeral 13 represents the semiconductor element (silicon chip), numeral 14 represents a die pad, numerals 15 and 17 represent supports, and numeral 16 represents a hotplate.

### (Measurement of Elastic Modulus)

The adhesive film was secured to a metal frame, and was then heat treated at 180°C for one hour. The storage elastic modulus of an adhesive film sample that had been cut to dimensions of 7 mm x 40 mm was measured using a Solid Analyzer RSA-II manufactured by Rheometrics Inc. The measurement conditions included using a tensile mode, a frequency of 1 Hz, a temperature range from -100 to 300°C, and a rate of temperature increase of 5°C/minute.

For the adhesive films obtained in the examples 1 to 2 and the comparative example 1, an evaluation of the reflow resistance using a BGA package, an evaluation of the high-temperature bonding property, and measurements of the storage elastic modulus upon heating, both before and after heat treatment, were also conducted.

**[Table 2]**

| Example No. | BGA reflow resistance (JEDEC level) | BGA reflow resistance (high-temperature bonding, JEDEC level) | High-temperature bonding test (230°C) | Elastic modulus after heat treatment (250°C) (MPa) | Elastic modulus before heat treatment (125-C) (NDa) |
|---|---|---|---|---|---|
| Example 1 | 2 | poor | poor | 1.3 | 0.08 |
| Example 2 | 2 | 2 | good | 1.0 | 0.5 |
| Comparative example 1 | 3 to poor | poor | poor | 0.1 | 0.06 |

### (BGA Reflow Resistance)

A silicon chip (6.5 mm × 6.5 mm × thickness: 280 µm) was die bonded to an organic substrate (thickness: 0.1 mm) with copper wiring (wiring height: 12 µm) that was provided with a solder resist layer of thickness 15 µm at the substrate surface, using an adhesive film (6.5 mm × 6.5 mm) and under conditions including 160°C, 300 gf/chip and a bonding time of 3 seconds. The adhesive film was then imparted with heat history equivalent to that associated with wire bonding by heating at 170°C for 3 minutes, and the entire structure was then subjected to transfer molding using an encapsulating material (molding temperature: 180°C, cure time: 2 minutes), and the encapsulating material was then cured by heating in an oven at 180°C for 5 hours, thereby yielding a semiconductor device (CSP-96 pin, encapsulated area: 10 mm × 10 mm, thickness: 0.8 mm).
This semiconductor device was subjected to moisture absorption under predetermined moisture absorption conditions prescribed by JEDEC, and was then passed three times through an IR reflow apparatus manufactured by Tamura Corporation (semiconductor device surface peak temperature: 265°C, temperature profile: adjusted in accordance with the JEDEC standard, based on the semiconductor device surface temperature). Subsequently, an ultrasonic inspection apparatus Hye-Focus, manufactured by Hitachi, Ltd., was used to inspect the device for peeling and/or breakdown of the adhesive film. The lack of this type of peeling or breakdown was used as the standard for evaluating the reflow resistance.

### (BGA Reflow Resistance, High-temperature bonding Conditions)

With the exception of conducting the die bonding process within the above BGA reflow resistance test under conditions of 230°C, 300 gf/chip and 3 seconds, the reflow resistance was evaluated in the same manner as that described above.

### (High-temperature Bonding Property)

An adhesive film cut to dimensions of 5 mm × 5 mm was sandwiched between a glass chip of dimensions 5 mm × 5 mm × 0.5 mm and an FR4 substrate (NEMA standard) of thickness 0.5 mm, compression bonding was then conducted at 180°C for 10 seconds using a loading of 1 kgf/chip, and the structure was then heated on a hotplate at 230°C for 2 minutes. The surface state of the adhesive film was then inspected through the glass chip, and adhesive films for which no foaming was visible to the naked eye were evaluated as "good", whereas those adhesive films for which foaming was visible were evaluated as "poor".

### (Measurement of Elastic Modulus)

The adhesive film was secured to a metal frame, and was then heat treated at 180°C for one hour. The heat-treated adhesive film and an adhesive film that had not undergone the heat treatment were each cut to dimensions of 7 mm x 40 mm. The storage elastic modulus of these cut adhesive films was measured using a Solid Analyzer RSA-II manufactured by Rheometrics Inc. The measurement conditions included using a tensile mode, a frequency of 1 Hz, a temperature range from -100 to 300°C, and a rate of temperature increase of 5°C/minute.

As is evident from the above results, by adjusting the storage elastic modulus of the cured adhesive film to a suitable value, the adhesive film of the present invention is able to exhibit excellent reflow resistance for both QFP and BGA. Furthermore, by suitable adjustment of the storage elastic modulus of the adhesive film prior to curing, bonding of a semiconductor element to a support member (or bonding of two semiconductor elements) can be conducted under a variety of bonding conditions, from a low temperature of 160°C through to a high temperature of 230°C.
The adhesive film of the present invention exhibits superior low-temperature adhesion to a variety of packages as well as superior reflow resistance and reliability, a combination of properties which has proven difficult to achieve with conventional technology. Moreover, if required, the adhesive film of the present invention is also able to withstand more severe bonding conditions, while retaining favorable low-temperature bonding performance, and superior reflow resistance and reliability.

## Claims

1. An adhesive film comprising a polyimide resin (A) and a thermosetting resin (B), wherein
the polyimide resin (A) comprises a polyimide resin having a repeating unit represented by a formula (I) shown below, and
a storage elastic modulus of the adhesive film at 250°C, following heat treatment at a temperature of 150 to 230°C for a period of 0.3 to 5 hours, is not less than 0.2 MPa: 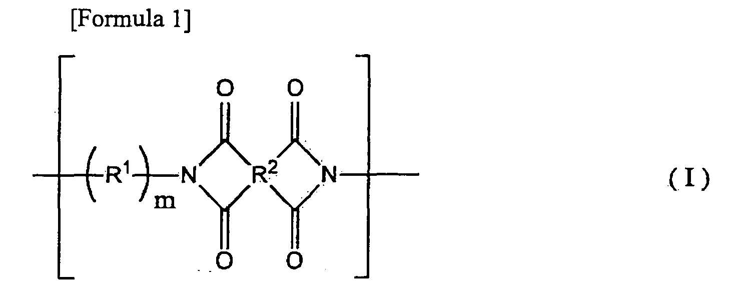 (wherein, m R¹ groups each represent, independently, a bivalent organic group, the m R¹ groups include a total of k organic groups selected from the group consisting of -CH₂-, -CHR- and -CR₂- (wherein, R represents a non-cyclic alkyl group of 1 to 5 carbon atoms), m represents an integer of not less than 8, m and k satisfy a relationship: k/m ≥ 0.85, and R² represents a tetracarboxylic acid residue).

2. The adhesive film according to claim 1, having a storage elastic modulus at 125°C prior to heat treatment of not less than 0.1 MPa.

3. The adhesive film according to either claim 1 or 2, wherein the polyimide resin (A) comprises a polyimide resin obtained by reacting a diamine and a tetracarboxylic dianhydride, and the diamine comprises not less than 50 mol% of a diamine represented by a formula (II) shown below: 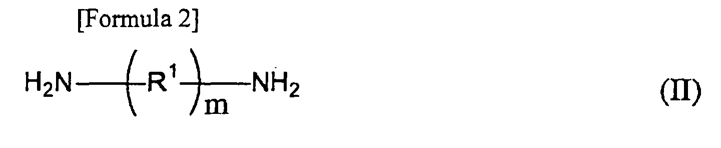 (wherein, m R¹ groups each represent, independently, a bivalent organic group, the m R¹ groups include a total of k organic groups selected from the group consisting of -CH₂-, -CHR- and -CR₂- (wherein, R represents a non-cyclic alkyl group of 1 to 5 carbon atoms), m represents an integer of not less than 8, and m and k satisfy a relationship: k/m ≥ 0.85).

4. The adhesive film according to claim 3, wherein the tetracarboxylic dianhydride comprises not less than 60 mol% of a tetracarboxylic dianhydride represented by a formula (III) shown below.

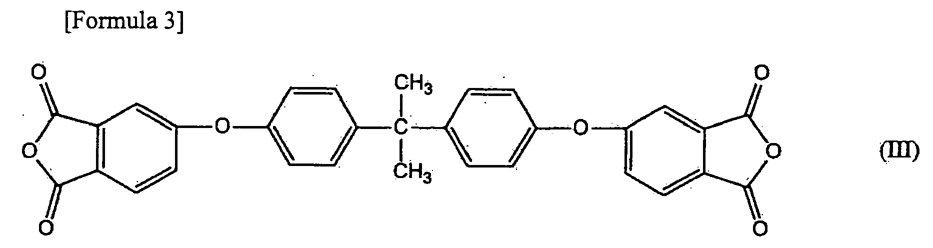

5. The adhesive film according to any one of claims 1 through 4, wherein the thermosetting resin (B) comprises an epoxy resin (B1) and an epoxy resin curing agent (B2).

6. The adhesive film according to claim 5, wherein the epoxy resin (B1) comprises a novolak epoxy resin represented by a formula (IV) shown below: 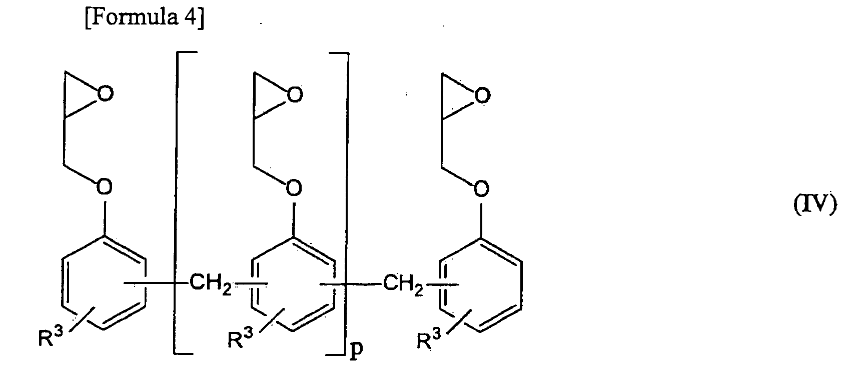 (wherein, each of a plurality of R³ groups represents, independently, a hydrogen atom, an alkyl group of 1 to 5 carbon atoms that may contain a substituent group, or a phenyl group that may contain a substituent group, and p represents an integer from 1 to 20).

7. The adhesive film according to either claim 5 or 6, wherein the epoxy resin curing agent (B2) comprises a phenol-based compound with a number average molecular weight within a range from 400 to 1,500 that contains two or more hydroxyl groups within each molecule.

8. The adhesive film according to any one of claims 5 through 7, wherein the epoxy resin curing agent (B2) comprises a naphthol-based compound that contains three or more aromatic rings within each molecule, or a trisphenol-based compound.

9. The adhesive film according to any one of claims 1 through 8, further comprising a filler (C).

10. The adhesive film according to claim 9, wherein the filler (C) has an average particle size of not more than 10 µm and a maximum particle size of not more than 25 µm.

11. The adhesive film according to any one of claims 1 through 10, comprising from 1 to 200 parts by weight of the thermosetting resin (B) per 100 parts by weight of the polyimide resin (A).

12. The adhesive film according to any one of claims 9 through 11, comprising from 1 to 8,000 parts by weight of the filler (C) per 100 parts by weight of the polyimide resin (A).

13. A semiconductor device having a structure in which the adhesive film according to any one of claims 1 through 12 is used to bond together a semiconductor element and a semiconductor element, or a semiconductor element and a support member.
